# EUROPEAN PATENT APPLICATION

(11) **EP 0 921 215 A1**
(43) Date of publication of application: **09.06.1999**
(21) Application number: 98122997.4
(22) Date of filing: 03.12.1998
(51) Int. Cl.: C30B 33/00, G03F 7/09

(54) **Electromagnetic radiation absorbant crystals of lithium niobate and lithium tantalate and methods of preparing the same**

(30) Priority: 05.12.1997 US 986312
(71) Applicant: CRYSTAL TECHNOLOGY, INC., Palo Alto, CA 94303 (US)
(72) Inventor: Bordui, Peter Frank, Palo Alto, CA 94306 (US); Jundt, Dieter Hans, Sunnyvale, CA 94087 (US); Norwood, Richard Gregory, San Jose, CA 95138 (US); Standifer, Eugene Michael, Sunnyvale, CA 94086 (US)
(74) Representative: Patentanwälte Westphal, Mussgnug & Partner

(57) **Abstract**

Crystals of lithium niobate and lithium tantalate are preconditioned to intentionally increase their absorbance of electromagnetic radiation used to expose photoresist applied to the crystals during photolithography. The observed increase in absorbance can reduce the amount of radiation transmitted to the backside of the crystal where the transmitted radiation may be reflected back towards the photoresist and expose undesired portions of the photoresist.

## Description

### Field of the Invention

The present invention relates to crystals of lithium niobate and lithium tantalate that have been preconditioned to increase their absorbance of electromagnetic radiation and methods of preconditioning such crystals for use in photolithography.

### BACKGROUND OF THE INVENTION

Lithium niobate (LN) and lithium tantalate (LT) are widely used in a variety of electronic applications including surface acoustic wave (SAW) signal processing, guided-wave optic modulation and switching, and electro-optic laser Q-switching, and modulation. The physical basis for the suitability of LN and LT crystals for these types of applications is their atomic-scale crystal structure, which results in the crystals' natural piezoelectric response useful in SAW-based devices, electro-optic response useful in integrated optic devices and pyroelectric response useful in pyroelectric detectors. Another characteristic of LN and LT that may be important in some applications is the optical absorption of the crystal. For example, integrated optic devices require a relatively small optical absorption, while other devices, such as SAW filters do not require a low optical absorption.

The photolithographic process is a step during which a geometric patterning necessary for desired device function is defined on the surface of a crystal wafer. The key process steps in a photolithographic process include the application of a photoresist, exposure of the photoresist to electromagnetic radiation that changes the solubility of the photoresist in a development solvent, and developing the resist. Subsequent steps may include etching of the crystal to remove regions not protected by the photoresist or metal deposition and then removal of the photoresist.

Manufacturers of devices incorporating LN or LT crystals are acutely sensitive to obtaining good definition, i.e. high contrast in the exposure and development of the photoresist. One factor that affects the contrast achieved is the ability to control precisely those portions of the photoresist that are exposed to the electromagnetic radiation that changes the solubility of the photoresist in the developing solution. Crystals of LN and LT are generally transparent to the electromagnetic radiation that is used to expose conventional photoresists. Since the photoresist preferably does not absorb all of the electromagnetic radiation to which it is exposed, a portion of the electromagnetic radiation is transmitted through the photoresist and into the LN or LT crystal. It is possible that a portion of this electromagnetic radiation transmitted through the crystal may be reflected at the backside surface of the crystal and expose unwanted portions of the photoresist, thus adversely affecting the ability of the photolithographic process to provide good definition and high contrast.

One method of reducing the reflection of electromagnetic radiation from the backside of the crystal has been to apply an anti-reflective coating to that surface. These anti-reflective coatings have been effective at reducing the amount of reflection occurring at the backside; however, they introduce extensive and costly process steps.

In view of the increasing demand for reliable LN and LT crystals for applications such as surface acoustic wave filter devices, guided wave optic modulation and switching, and electro-optic Q-switching and modulation, the need exists for improvements in LN and LT crystals that continue to exhibit properties that make them desirable for such applications and that do not suffer from the drawbacks associated with the undesirable reflection of radiation used to expose photoresist or the cost and complications associated with current production protocols for reducing such reflection.

### SUMMARY OF THE INVENTION

In accordance with the present invention, crystals of LN or LT are preconditioned to increase the ability of the crystal to absorb electromagnetic radiation used to expose a photoresist carried on a surface of a LN or LT crystal wafer, and thereby reduce, and in some situations eliminate, reflection of the electromagnetic radiation from the backside of the wafer. The present invention reduces, and preferably eliminates, drawbacks such as contrast losses, caused by reflection of the electromagnetic radiation from the backside of the wafer. The present invention achieves these results by absorbing a portion of the electromagnetic radiation that is transmitted through the photoresist and into the crystal, thus reducing the amount of radiation available for reflection from the wafer backside and by absorbing a portion of any radiation that is reflected from the backside of the wafer.

The present invention also relates to a method for preconditioning an LN or LT crystal to increase the crystal's ability to absorb electromagnetic radiation used to expose photoresist on the crystal surface. In a preferred embodiment of the method aspect of the present invention, the ability of the crystal to absorb electromagnetic radiation is increased by exposing the crystal to a combination of heat and a chemically reducing atmosphere to alter the radiation transmitting properties of the crystal.

### DESCRIPTION OF THE PREFERRED EMBODIMENT

The LN (the compound formed from Li₂O and Nb₂O₅) and LT (the compound formed from Li₂O and Ta₂O₅) crystals of the present invention exhibit piezoelectric and pyroelectric responses that make the crystals suitable for applications such as surface acoustic wave (SAW) signal processing, guided-wave optic modulation and switching, and electro-optic laser Q-switching and modulation. The present invention is described below in the context of LN crystals; however, the description is believed to be equally applicable to other types of crystals such as LT.

LN and LT crystals can be grown by a number of techniques, the most well-known of which is the Czochralski technique. A summary of the Czochralski technique can be found in Current Topics and Material Science, Vol. 1, E. Kaldis editor, North Holland Publishing Co., 1978, ch. 7 by Dr. Armin Räuber, p. 545-48, which is herein incorporated by reference. LN crystals grown by the Czochralski technique are achieved by pulling LN from a melt. Nearly any kind of conventional crystal pulling apparatus can be used. The crucible in which the LN is heated can be platinum. There are no special demands for the atmosphere, with air in many situations being preferred.

As noted in the background of the invention and illustrated in the Comparative Example, LN crystals for use in optic devices are generally colorless and transparent at the wavelengths typically used to expose photoresist. Thus, electromagnetic radiation used to expose a photoresist carried on wafers of these crystals is readily transmitted through the wafer and can be reflected back towards the photoresist from the wafer backside. In contrast, as described in the Example that follows the Comparative Example, preconditioned LN wafers of the present invention are not colorless or transparent and therefore are able to absorb to varying degrees electromagnetic radiation used to expose conventional photoresists. By increasing the crystal's ability to absorb electromagnetic radiation, (1) the amount of radiation transmitted to the backside of the wafer is reduced; and (2) the amount of radiation reflected from the backside that is transmitted back through the wafer to the photoresist is reduced. Both of these results reduce the amount of reflected radiation available to expose unwanted portions of the photoresist and thereby adversely affect contrast of the desired photoresist pattern.

Electromagnetic radiation used to expose photoresists applied to the wafer surface depends on the type of photoresist employed and is chosen so that upon exposure, the solubility of the photoresist in a developing solution is altered either positively or negatively. Examples of sources of electromagnetic radiation that are used to expose conventional photoresists include mercury vapor lamps which emit intense radiation in the blue-violet/ultraviolet region of the spectrum. A xenon flash tube is another example of a source of electromagnetic radiation suitable for exposing photoresists. Preferably, LN crystals of the present invention are able to absorb at least electromagnetic radiation that falls within the range needed to impact the solubility of the photoresist. Accordingly, when a mercury vapor lamp is the source of electromagnetic radiation, it is preferred that the preconditioned LN crystal absorb radiation in the blue-violet/ultraviolet region of the electromagnetic spectrum.

Preferably, the crystal's ability to absorb the electromagnetic radiation used to expose the photoresist is increased without a significant change in other physical and electrical properties that make the crystal desirable for its intended purpose. While the present invention is being described in the context of the electromagnetic radiation used during the step of exposing the photoresist, the advantages of the present invention are not necessarily limited to this segment of the photolithographic process.

A preferred process for preconditioning LN crystals is described below. Other techniques capable of increasing the ability of the crystal to absorb electromagnetic radiation used to expose the photoresist without adversely affecting the other physical and electrical properties of the crystal can also be used in accordance with the present invention. The specific process described below is preferred, due to its simplicity and ease of control.

Preconditioned crystals of the present invention, unlike crystals that have not been preconditioned, exhibit a color ranging from light grey to dark blue or black. The crystals may be lightly colored or they may be opaque, depending on the conditions that are used to precondition the crystal. In view of this color change, the preconditioned crystals of the preferred embodiment are preferred for applications where optical absorption is not a critical crystal property.

One process for preconditioning an LN crystal in accordance with the present invention involves exposing wafers of LN crystals to heat under a chemically reducing atmosphere. After the wafers are exposed to the desired temperature, they are allowed to cool back to room temperature. Suitable preconditioning of LN crystal wafers can be achieved by exposing the wafers to target temperatures in an oven greater than about 500°C under an 85% nitrogen gas and 15% hydrogen gas atmosphere for dwell times on the order of about one to about 200 minutes. After the wafers have been exposed to the target temperature, they can be cooled to room temperature.

In addition to those described above and in the Example that follows, other target temperatures heat up and cool down rates, dwell times and atmospheres suitable for increasing the ability of the crystal to absorb electromagnetic radiation without adversely affecting the desirable performance properties of the crystal can be employed. For example, in addition to the hydrogen and nitrogen gas mixture described below, other gases such as hydrogen alone, nitrogen alone, argon, water, carbon dioxide, carbon monoxide, oxygen, and combinations thereof can be used in accordance with the present invention. A combination of 85% nitrogen gas and 15% hydrogen gas is preferred because of its ready availability from numerous commercial sources. It is contemplated that different gas mixtures will provide different results so far as the extent of the reduction that is achieved.

The rate at which the crystal wafers are heated is not believed to be critical. Effective preconditioning of LN crystals can be achieved at heat up rates of about 6°C to about 7°C per minute. Likewise, the cool down rate is not believed to be critical and effective preconditioning of LN crystals can be achieved at cool down rates ranging from about 0.5°C to about 1°C per minute. Other heating rates and cooling rates that are either greater or less than those set forth above may also be used.

Effective preconditioning is achieved at oven temperatures above 500°C. Preferably, the oven temperature ranges from about 500°C to up to about 1,140°C (the Curie temperature for lithium niobate) and most preferably from about 750°C up to about 1,140°C. The higher temperatures are preferred because they provide a greater increase in the ability of the crystal to absorb electromagnetic radiation in the blue-violet and ultraviolet region of the electromagnetic spectrum compared to temperatures near the lower end of the ranges. For oven temperatures closer to the lower end of the ranges noted above, an increase in the absorbance of the crystal is observed, but the increase is not as great compared to the increase observed at the higher temperatures. An increase in the absorbance of electromagnetic radiation by the crystals is also observed at temperatures below about 500°C although such increases are less than those observed at temperatures greater than 500°C. As discussed above, depending upon the effect of the preconditioning on other properties of the crystal, the lower temperatures may be suitable and in fact preferred.

The dwell times that the crystals are exposed to the target temperature in accordance with the present invention can vary. Increasing the dwell times for a given target temperature and atmosphere should increase the ability of a crystal to absorb electromagnetic radiation used to expose a photoresist compared to crystals exposed to the target temperature for shorter dwell times. Shorter dwell times are preferred from the standpoint of minimizing process times and energy requirements for the process.

As set forth in more detail below in the Comparative Example and the Example that follows, preconditioned LN crystal wafers of the present invention exhibit an increase in optical absorbance compared to conventional LN wafers that have not been preconditioned in accordance with the present invention.

### Comparative Example

This comparative example illustrates the absorbance properties of a conventional LN crystal that has not been preconditioned in accordance with the present invention.

A wafer of LN 76 mm in diameter and 0.5 mm thick oriented with the surface normal to the 64° rotated y-direction was prepared using the Czochralski method and a conventional fabrication method. The wafer was polished on one side and was colorless and translucent upon visual inspection.

### Example

In this example, LN wafers are preconditioned to increase their ability to absorb electromagnetic radiation typically used to expose conventional photoresists.

Wafers of LN were cut from the same boule that served as the source of the wafer in the Comparative Example. The wafers were polished and lapped in an identical manner as the wafer described in the Comparative Example. These wafers were placed in a sealed oven through which a mixture of 85% nitrogen gas and 15% hydrogen gas was flowed at a rate of approximately 1.5 liters per minute. The oven comprised a three-zone tube furnace with a horizontal, 4-inch diameter alumina process tube. The wafers were supported by alumina carriers placed in the center of the process tube. The alumina process tube extended out of the furnace so that its ends were exposed and remained cool. O-ring seals on the alumina process tube provided a sealed furnace cavity. The wafer was loaded into the process tube which was then sealed with end caps. The gas flow was initiated and the furnace heating schedule begun. The furnace temperature was increased from room temperature to the target temperature at a rate of about 6.7° per minute. Once the target temperature was reached, the temperature was maintained for a predetermined dwell time. After the dwell time, the furnace was allowed to cool naturally. After cooling, the wafers were removed from the furnace and their visual appearance was observed qualitatively and recorded. X-ray diffraction analysis confirmed the original crystal structure of the material. The wafers were visually inspected for color and opacity. The results are summarized in Table 1.

| Furnace Target Temperature (°C) | Dwell Time (minutes) | Color |
|---|---|---|
| 80°C (Comparative Example) | - | colorless/translucent |
| 400 | 1 | very light grey-colorless/translucent |
| 400 | 200 | grey/translucent |
| 500 | 1 | grey/translucent |
| 550 | 1 | grey/translucent |
| 650 | 1 | dark grey/translucent |
| 700 | 1 | black/opaque |
| 750 | 1 | black/opaque |
| 800 | 1 | black/opaque |
| 1030 | 1 | black/opaque |

The observed change in the color of the crystals in the Example indicates the ability of the crystals to absorb electromagnetic radiation, such as blue-violet light or ultraviolet light.

It is believed that the concepts of the present invention can easily be applied to various LN or LT crystals having a wide variety of physical characteristics, such as wafers of varying diameters, thicknesses and orientations. This can be accomplished by selecting appropriate furnace temperatures, dwell times, chemically reducing atmospheres and other parameters. The concepts of the present invention could also be applied to wafers either before or after the wafers have been polished, or even to slabs of crystal material. In addition, the method of the present invention may be performed at different stages of the manufacturing of devices, such as after cleaning or metal deposition on the wafers.

The advantages provided by preconditioned crystals of the present invention and the method of preconditioning crystals in accordance with the present invention are applicable to LN and LT crystals that are subjected to manufacturing conditions that involve the unwanted transmission of electromagnetic radiation through the crystal wafer. The ability of crystals preconditioned in accordance with the present invention to absorb electromagnetic radiation is not believed to adversely affect the ability of the crystal to perform in its intended manner in those situations where low optical absorption is of little concern, e.g., SAW based devices.

## Claims

The embodiments of the invention in which an exclusive property or privilege is claimed are defined as follows:

1. A crystal for use in a photolithographic process to produce patterned lithium niobate or lithium tantalate crystals for use in electronic or optical applications comprising:
a crystal of lithium niobate or lithium tantalate preconditioned to increase the ability of the crystal to absorb electromagnetic radiation used to expose a photoresist applied to the crystal.

2. The crystal of Claim 1, wherein the crystal has been exposed to a combination of heat and a chemically reducing atmosphere to increase the ability of the crystal to absorb the electromagnetic radiation.

3. The crystal of Claim 2, wherein the crystal has been exposed to a temperature greater than about 500°C.

4. The crystal of Claim 3, wherein the temperature ranges between about 500°C and about 1,140°C.

5. The crystal of Claim 2, wherein the chemically reducing atmosphere comprises gases selected from argon, water, hydrogen, nitrogen, carbon dioxide, carbon monoxide, oxygen, and combinations thereof.

6. The crystal of Claim 1, wherein the electromagnetic radiation falls in the blue/violet region of the spectrum or the ultraviolet region of the electromagnetic spectrum.

7. A method for preconditioning a lithium niobate or lithium tantalate crystal to increase the crystal's ability to absorb electromagnetic radiation used to expose photoresist applied to the crystal comprising:
treating the crystal to increase its absorbance of electromagnetic radiation.

8. The method of Claim 7, where the treating of the crystal to increase its absorbance of electromagnetic radiation further comprises:
exposing the crystal to a combination of heat and a chemically reducing atmosphere to increase the absorbance of electromagnetic radiation by the crystal.

9. The method of Claim 8, wherein the crystal has been exposed to a temperature greater than about 500°C.

10. The method of Claim 9, wherein the temperature ranges between about 500°C to about 1,140°C.

11. The method of Claim 7, wherein the chemically reducing atmosphere comprises gases selected from argon, water, hydrogen, nitrogen, carbon dioxide, carbon monoxide, oxygen, and combinations thereof.

12. The method of Claim 7, wherein the electromagnetic radiation falls in the blue-violet region of the electromagnetic spectrum or the ultraviolet region of the electromagnetic spectrum.
